(19) Europäisches Patentamt

European Patent Office

Office européen des brevets

(11) **EP 2 422 352 B1**

(12) **EUROPEAN PATENT SPECIFICATION**

(45) Date of publication and mention of the grant of the patent:
**06.01.2016 Bulletin 2016/01**

(21) Application number: **10719043.1**

(22) Date of filing: **20.04.2010**

(51) Int Cl.:
***H01J 37/32*** *(2006.01)*      ***H01J 37/34*** *(2006.01)*

(86) International application number:
**PCT/GB2010/050641**

(87) International publication number:
**WO 2010/122331 (28.10.2010 Gazette 2010/43)**

(54) **RF-PLASMA GLOW DISCHARGE SPUTTERING**

RF-PLASMA-GLÜHENTLADUNGS-SPUTTERN

PULVÉRISATION CATHODIQUE À DÉCHARGE LUMINESCENTE DE PLASMA RF

(84) Designated Contracting States:
**AT BE BG CH CY CZ DE DK EE ES FI FR GR HR HU IE IS IT LI LT LU LV MC MK MT NL NO PL PT RO SE SI SK SM TR**

(30) Priority: **23.04.2009 GB 0906935**

(43) Date of publication of application:
**29.02.2012 Bulletin 2012/09**

(73) Proprietor: **Sheffield Hallam University South Yorkshire S1 1WB (GB)**

(72) Inventors:
- **EHIASARIAN, Arutiun**
  **Sheffield South Yorkshire S1 1WB (GB)**
- **HOVSEPIAN, Papken**
  **Sheffield South Yorkshire S1 1WB (GB)**
- **YUKIMURA, Ken**
  **Moriyama-City**
  **Shiga 524-0022 (JP)**

(74) Representative: **Neilson, Martin Mark**
**Urquhart-Dykes & Lord LLP**
**Tower North Central**
**Merrion Way**
**Leeds LS2 8PA (GB)**

(56) References cited:
**WO-A2-02/091461      US-B1- 6 193 855**

- **JOO JUNGHOON: "Ionization enhancement in ionized magnetron sputter deposition" JOURNAL OF VACUUM SCIENCE AND TECHNOLOGY: PART A, AVS /AIP, MELVILLE, NY., US LNKD- DOI:10.1116/1.582153, vol. 18, no. 1, 1 January 2000 (2000-01-01), pages 23-29, XP012004919 ISSN: 0734-2101 cited in the application**

EP 2 422 352 B1

## Description

The present invention relates to RF-glow discharge sputtering using an RF antenna to generate a plasma of ion species used for sputtering in which the peak power density at the RF antenna is greater than 50 Wcm$^{-2}$.

High power impulse magnetron sputtering plasma is an emerging technology used to modify the surfaces of industrial components and biomedical parts. The characteristic feature of the plasma is that metallic species are highly ionized and charged particles are magnetized. In order to use the plasma source in a variety of material processing applications, it is desirable that the glow is generated without a magnetic field.

Plasma-ion processing prepares ceramic films in order to enhance their functionality. Typical examples include the electrical properties of conductivity or insulation in semiconductor devices and the tribological properties of industrial components. Metallic plasma sources are indispensable in the preparation of high-quality films, as they work in a manner that supplies highly-purified and uniformly distributed metallic species to a given region with high density. An Arc-free plasma is usually desired to avoid the degradation of the prepared films.

A magnetron sputtering system operated by a pulsed high current was proposed at the end of the 1990s by Kouznetsov et al [V. Kouznetsov, K. Macák, J. M Schneider, U. Helmersson and I. Petrov: Surf. Coat. Technol., 122 (1999) 290-293]. The method is referred to as HIPIMS (high power impulse magnetron sputtering) [A.P.Ehiasarian, W.-D.Münz, L.Hultman, U.Helmersson, I.Petrov, Surf. Coat. Technol. 163-164 (2003) 267] or HPPMS (high power pulsed magnetron sputtering) [D.J.Christie, J. Vac.Sci.Technol. A 23 (2005) 330]. A glow generation method that uses a Penning discharge has also been proposed [K.Yukimura, R.Mieda, H.Tamagaki, T.Okimoto, Phys. Stat. Sol. (a), 205, No.4, 949-952 (2008)]. Such methods typically involve a power density of the order of ~kW/cm$^2$ for discharge currents of 0.1 - 10 A/cm$^2$ and glow voltages of 400-1000 V.

When a magnetic field is used in the plasma region, charged particles may not be accelerated directly along the electric field. This causes not only random ionic motion, but also a non-conformal ion implantation and deposition in material processing. It is therefore desirable to generate a metallic plasma in the absence of a magnetic field for enhanced uniformity of film preparation and conformal ion implantation.

A high current glow discharge plasma has previously been generated in the 1970's by combining a pulsed dc power source with an RF power source (as described by Malkin [O.A.Malkin, "Pulsed current and relaxation in gas", pp. 27-39, 1974, ATOMIZDAT, Moscow (in Russian)]).

Joo [J. Vac. Sci. Technol. A 18(1), Jan/Feb 2000] discloses ionized magnetron sputter deposition using a pulsed power RF antenna. The medium frequency (55 kHz) sputtering power was pulsed with various on/off duty cycles. To address the problem of ionized metal species from the cathodic target returning to the cathode, the DC power to the target was also pulsed and an axial magnetic field applied to reduce coil sputtering at high inductively coupled plasma power.

WO 02/091461 discloses ionized PVD apparatus for both deposition and etching of the substrate. US 6,193,855 discloses apparatus and a method for depositing a layer of material on a substrate using ionized plasma and a modulated signal.

However, known glow discharge sputtering apparatus and methods have limited effectiveness when employed for substrate etching and/or coating deposition. In particular, the inventors have determined that due to the nature of the plasma generated with conventional systems, etching of the substrate surface is poor. This is due, in part, to the relatively low ionization degree of the sputtered species. Moreover, poor substrate-coating adhesion is also observed in addition to the attainment of low to modest coating density at the substrate. What is required is sputter apparatus and method that solves the above problems.

Accordingly, the inventors provide an RF-plasma glow discharge apparatus and method exhibiting enhanced ionization efficiency of the metal vapour by the plasma due to the production of high density plasma using an RF antenna which is driven at an enhanced and high impulse RF power. In particular, the inventors provide apparatus and method configured to generate a peak power density at the RF antenna of greater than 50 Wcm$^{-2}$. This high power at the antenna in turn generates a high plasma density yielding: a) high target currents so as to achieve relatively high target sputter rates, and b) high probability of ionization of the sputtered species. Accordingly, the present apparatus and method is configured to generate dense highly ionized plasma.

The high density, high energy ionic species significantly improve the density of the coating microstructure at the substrate. When employed for substrate surface etching and/or substrate pre-treatment prior to coating, etching speed and coating adhesion is enhanced.

The highly ionised plasma also provides increased spatial uniformity of the coating thickness. Accordingly, metal or ceramic deposition at substrates with a high aspect ratio (extremely contoured surface profiles, typically found on microchips) and other complicated substrate profiles is made possible with desired coating uniformity.

The present apparatus and method generates highly ionised plasma and allows for deposition without the use of magnetic fields. It is therefore suitable for sputtering and deposition of magnetic materials due to the absence of magnetic field containment. The present system is also configured for sputtering ceramic materials and the stable deposition of oxides. Importantly target surface charging is avoided and unwanted arcing is minimised within the present system.

High plasma densities are achieved by pulsing power at the antenna and the cathodic sputter target using relatively low impedance power sources to achieve the required high ion flux at the region of the RF antenna. In particular, it has been found that optimum conditions to generate the highly dense plasma ion species from the sputter target is achieved when the plasma impedance $Z_p$, measured at the target, substantially matches the output impedance of the target power supply $Z_h$. The output impedance of the power supply is the sum of the output impedance of the target power source $Z_{ps}$ and the impedance of any additional units $Z_{ex}$, such as resistors. The optimum condition may be given by:

$$Z_h = Z_{ps} + Z_{ex} = Z_p$$

where $Z_{ps}$ and $Z_{ex}$ are fixed by the nature and design of the power supply. The plasma impedance $Z_p$ may vary over a wide range and depends on the plasma density which is controlled by the RF antenna power. Accordingly, there exists an antenna power range where approximate impedance matching occurs and the maximum density of sputtered metal ion species is achieved. The plasma impedance $Z_p$ may change throughout the duration of any one power pulse.

Optimum density generation of the ionized sputtered species is further provided by an approximate synchronisation of the pulsed power at the RF antenna and the cathodic target. Reference to 'synchronization' of the pulse power at the RF antenna and cathodic target includes synchronization of the pulse power duration at the antenna and target. Additionally, synchronization may also be applied to the start and termination of power to the respective RF antenna and cathodic target. Synchronization may also include a correlation between the combination of start and termination of power supply to either the RF antenna and the cathodic target, and the duration of the power pulse to either the RF antenna and/or the cathodic target.

In an example not forming part of the invention, the power at the target may be applied in a continuous DC mode, so as to allow sputtering even when the RF antenna is in the off stage.

According to a first aspect of the present invention there is provided a RF-plasma glow discharge apparatus comprising: a containment chamber in which to generate a plasma of ion species; means to pulse the power to a sputter target from which the ion species are generated; an RF antenna to generate the plasma of ion species; means to pulse the power at the RF antenna; wherein the peak power density at the RF antenna is greater than 50 Wcm$^{-2}$.

The peak power density at the RF antenna may be in the range 50 Wcm$^{-2}$ to 5000 Wcm$^{-2}$. Preferably, the peak power density at the RF antenna may be in the range 200 Wcm$^{-2}$ to 1800 Wcm$^{-2}$. More preferably, the peak power density at the RF antenna is in the range 800 Wcm$^{-2}$ to 1600 Wcm$^{-2}$.

In one implementation, the apparatus comprises means to provide pulsed DC power at the sputter target. Pulsed DC power at the target is particularly suitable where the target is metallic. Alternatively, the apparatus may comprise means to provide RF power at the target substrate, particularly where the target substrate is a ceramic or an oxide. The RF antenna may be located inside or outside the containment chamber.

Preferably, the discharge current density at the region of the target is in the range 0.03 Acm$^{-2}$ to 3 Acm$^{-2}$. More preferably, the discharge current density at the region of the target is in the range 0.5 Acm$^{-2}$ to 1.5 Acm$^{-2}$. Preferably, the peak power density at the target is greater than 10 Wcm$^{-2}$. Preferably, the pulse frequency at the RF antenna is not greater than 10 kHz. Preferably, the RF frequency at the RF antenna is in the range 0.05 MHz to 500 MHz. More preferably, the RF frequency at the RF antenna is in the range 200 kHz to 100 MHz.

Preferably, a duty cycle at the RF antenna is in the range 0.5% to 50%. More preferably, a duty cycle at the RF antenna is in the range 8% to 12%.

Preferably, the RF pulse duration at the antenna is between 1 and 10000 $\mu$s. More preferably, the pulse duration at the RF antenna is in the range of 30 to 3000 $\mu$s. Controlling the pulse duration is advantageous to produce high ionisation plasma. In particular, a minimum pulse duration is required so as to allow time for the desired quantity of plasma to build-up. In contrast, an excessively long pulse duration may cause the antenna and/or target to overheat. The inventors therefore provide a controlled and optimised pulse duration.

The apparatus may further comprise means to synchronise the pulsed power at the sputter target and the RF antenna. In one embodiment, the means to synchronise comprises a communication and a control means coupled to the sputter target and the RF antenna such that the sputter target and RF antenna operate to generate power according to a master and slave synchronised configuration. More preferably, the apparatus may further comprise control means coupled to the sputter target and the RF antenna, the control means configured to synchronise the power at the sputter target and the RF antenna.

Preferably, an impedance of the plasma substantially equals an output impedance of a power supply to the target electrode. Preferably, an impedance of the plasma is within the range 0.2 to 400 times an output impedance of a power supply to the target electrode. Preferably, the pulsed DC power at the target is greater than 200 V. Alternatively, where RF target power is used, the RF power at the target comprises a self-bias of greater than 200 V.

Optimally, the apparatus may further comprise an array of magnets positioned at the region of the sputter target.

The present apparatus and method may be utilised with a variety of different process gases from which to generate plasma species. The process gas for use within the containment chamber may comprise any one or a combination of the following set of: Ne; Ar; Kr; Xe; $N_2$; $O_2$; $CH_4$; $C_2H_2$ and/or a silane.

According to a second aspect of the present invention there is provided an RF-plasma glow discharge process comprising: pulsing power at a sputter target from which a plasma of ion species is generated within a containment chamber; pulsing power at an RF antenna to generate the plasma of ion species; and generating a peak power density at the RF antenna of greater than 50 $Wcm^{-2}$.

According to the present system, an initial RF discharge at the antenna serves to produce plasma, which is accelerated by the electric field generated by a negative voltage applied to the sputter target. The sputtered species are then ionized by the RF discharge. Accordingly, the RF power source provides a gas breakdown to yield gas ions, whilst the target electrode is used for gas ion acceleration and sputtering. The apparatus and method of the present invention may therefore be used without a magnetic field for sputtering of magnetic metallic species.

A specific implementation of the present invention will now be described, by way of example only, and with reference to the accompanying figures in which:

figure 1 is a schematic illustration of the experimental arrangement according to a specific implementation of the present invention;

figure 2 illustrates schematically the correlation between the power pulse applied to the RF antenna and target substrate where the target is powered by a DC impulse according to the specific implementation of the present invention;

figure 3 illustrates schematically the correlation between the power pulse applied to the RF antenna and sputter target where the target is powered by a RF impulse according to a further specific implementation of the present invention;

figure 4 illustrates schematically the correlation between the power pulse applied to the RF antenna and target substrate where the target is powered by a DC impulse and an array of magnets are positioned at cathodic target;

figure 5 illustrates the optical emission intensity versus the peak power density at the RF antenna;

figure 6 illustrates the optical emission intensity versus plasma impedance;

figure 7 illustrates synchronisation of the power pulse and pulse duration of the RF antenna and the cathodic target according to a specific implementation.

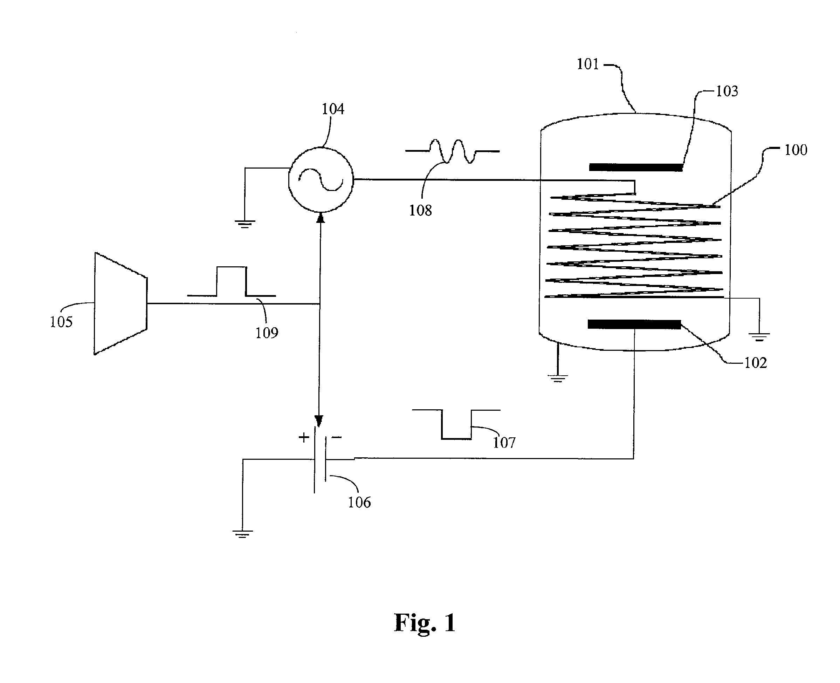

Referring to figure 1, the experimental apparatus comprises an RF antenna 100 mounted within a containment vacuum chamber 101. A first electrode 102 is configured as the cathodic sputtering target and a second electrode 103 is formed by the substrate that ultimately receives the plasma of ion species.

An RF power supply 104 is connected to antenna 100 and a control pulse 109 is generated from a pulse signal generator 105 in response to an RF pulse (impulse) generated at the RF power supply 104 to provide an RF impulse at antenna 100 such that the peak power density at antenna 100 is greater than 50 $Wcm^{-2}$. In particular, the peak power density at RF antenna 100 is in the range 400 to 1800 $Wcm^{-2}$.

The plasma source consists of a capacitor and an inductor 100, which are used to generate an RF-ICP (Inductively Coupled Plasma). A pulsed negative voltage 107 is applied to one of the electrodes 102 to draw ions produced in the RF plasma. The electrode 102 is connected to a pulsed DC power source 106, via a current limiting 10 Ω resistor (not shown), (of rated power: 800 W) and an IGBT (Insulated Gate Bipolar Transistor) switch (not shown). The pulsed power 106 has a 300 A current capability for a maximum output voltage of 1.5 kV with negative polarity. The timing of pulsed voltage application to the electrode 102 is controlled using the pulse generator 105 (PuG).

The ambient gas is 99.99% pure argon, which is supplied using a mass flow controller (not shown) from a gas inlet (not shown) positioned at an opposite side of the contamination chamber 101. The gas pressure inside the chamber 101 may be varied from 0.1 Pa to 100 Pa, and is preferably 0.6 Pa.

The pumping unit consists of a turbo molecular pump (not shown) and a rotary pump (not shown) with volume flow rates of 350 L/s and 100 L/s, respectively. The pressure is measured at the side of the pumping unit using a Pirani gauge (not shown).

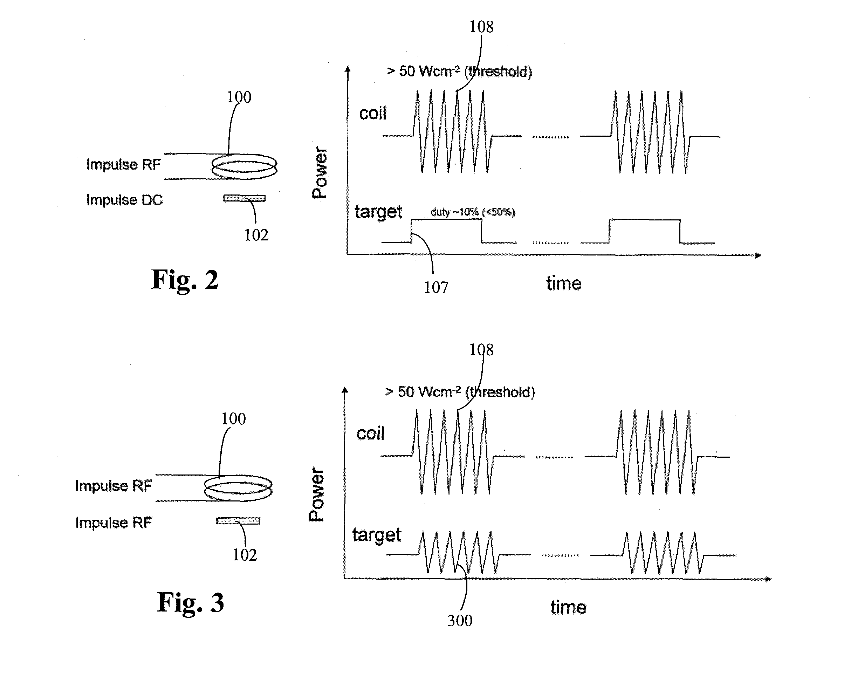

Figure 2 illustrates the waveforms of the impulse power of antenna 100 and sputter target 102 according to the experimental arrangement of figure 1 in which a DC pulse 107 is supplied to sputter target 102. The peak power density resultant from the RF impulse 108 at antenna 100 is greater than 50 $Wcm^{-2}$ and is in particular between 1,000 to 1,400 $Wcm^{-2}$. This level of peak power generates a high density of plasma and metal ion species, that is advantageous for substrate implantation and deposition. The frequency of the RF power pulse is 200 kHz. However, a peak power of greater than 50 $Wcm^{-2}$ is achievable with a frequency in the range 0.05 MHz to 500 MHz.

As illustrated in figure 2, the RF power pulse 108 and DC power pulse 107 are synchronised via pulse signal generator 105 coupled to both the RF power supply and the DC power supply 106. According to the specific implementation, there is no delay between application of the RF power pulse 108 and DC power pulse 107. This synchronisation of the impulses has been found to improve ionisation efficiency as the RF power pulse 108 is believed to be responsible to generate the main plasma whilst the target power pulse 107 is used to start the sputtering process.

The duty cycle at the RF antenna 100 is 2% representing the average power density output at antenna 100 divided by the peak power density. The present invention is configured for a duty cycle range at the coil of between 0.5 to 50%.

Operating with a DC power pulse 107, the peak power density at sputter target 102 is greater than 10 Wcm$^{-2}$ with a discharge current density at target 102 of 0.03 to 3.0 Acm$^{-2}$ and in particular 1 Acm$^{-2}$.

Figure 3 illustrates a further implementation of the present invention in which sputter target is supplied with an RF power impulse 300. This configuration is particularly suitable for ceramic material targets or oxide deposition. As with the DC power impulse to target 102 of figure 2, the dual RF impulse configuration of figure 3 is synchronised with regard to the start, finish and pulse duration times of the RF impulse to the coil 100 and target 102 so as to optimise generation of a dense plasma of highly energised sputtered ion species.

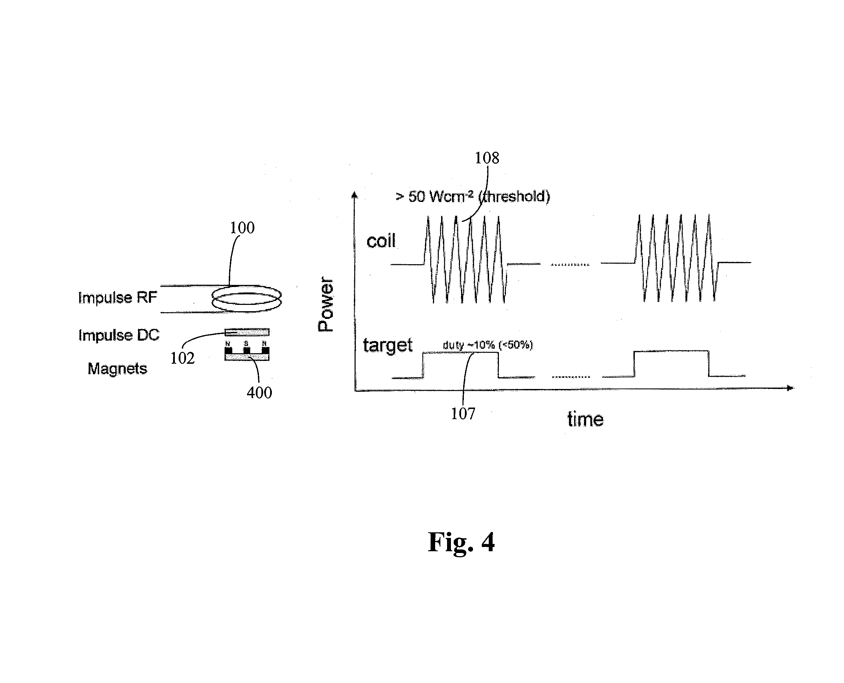

Figure 4 illustrates a further embodiment of the present invention in which an array of magnets 400 is positioned at sputter target 102 so as to provide a magnetic containment field at the region of target 102. The magnetron arrangement of figure 4 is implemented with a DC power pulse 107 according to figure 2. The experimental arrangement of figure 4 is suitable for sputtering non-magnetic materials and in particular metallic materials.

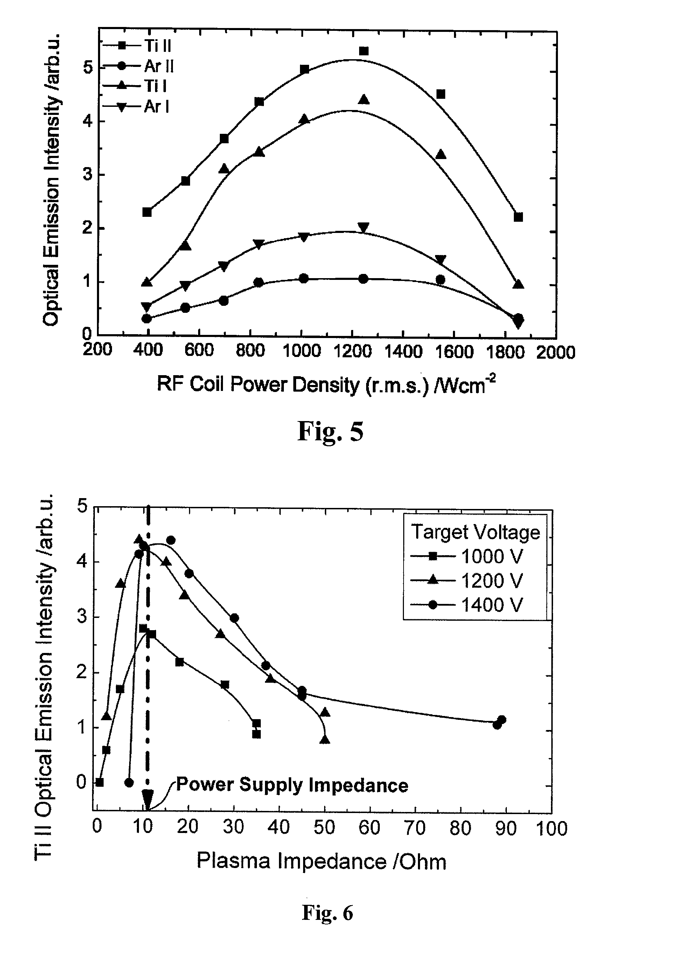

Figure 5 illustrates the correlation between the peak power density at the RF antenna 100 and the density of plasma ion species generated (expressed as the optical emission intensity). Being evident from figure 5, a maximum plasma intensity is achieved with an RF antenna peak power density of between 1000 to 1400 Wcm$^{-2}$. The inventors have found that the efficiency and quality of substrate etching and coating deposition is significantly greater than conventional apparatus and methods that use an RF antenna peak power density of less than 50 Wcm$^{-2}$.

Figure 6 illustrates the effect of matching the plasma impedance $Z_p$, which is measured at the target, with the output impedance $Z_{ps}$ of the power source 106 supplied to target 102. To determine the optimum impedance of the plasma and the target power supply, the power supply impedance at the target was maintained at a constant 12 Ohms. The plasma impedance was increased from 0.2 to 90 Ohms by reducing the peak power 108 at the RF antenna 100. The amount of Ti II ions produced was determined by observing their optical emission intensity from the plasma. It was observed that when the plasma impedance equaled the target power supply impedance and were therefore matched, the highest optical emission intensity of the Ti II ions were generated. This corresponded to a plasma impedance of approximately 12 Ohms as illustrated in figure 6.

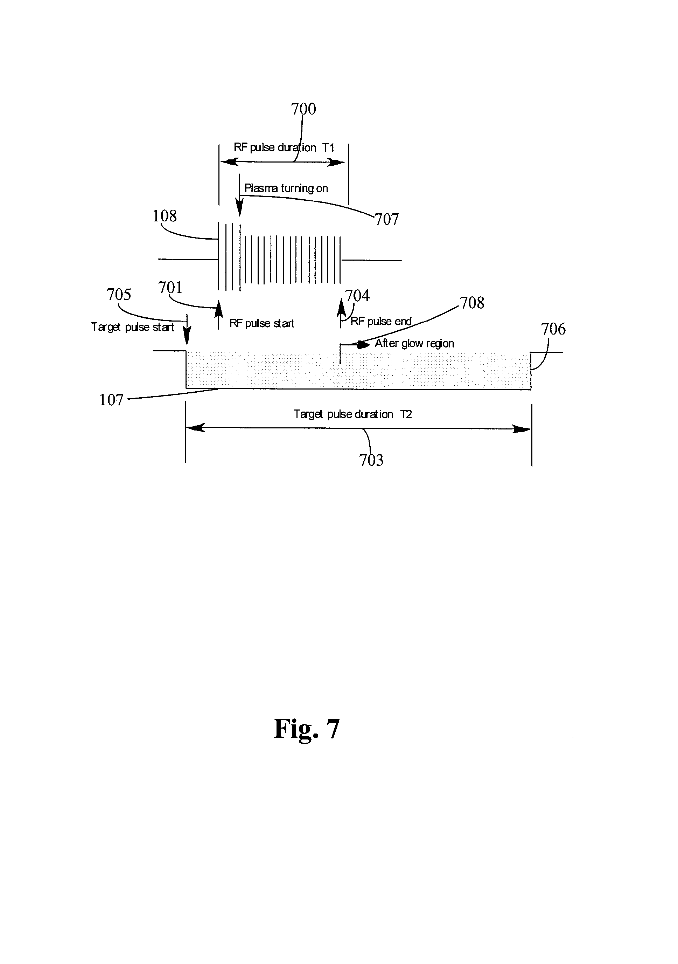

Figure 7 illustrates a preferred configuration of the synchronization of the RF impulse 108 supplied to the antenna 100 and the DC power pulse 107 supplied to target 102. According to the preferred configuration, target pulse 107 is started 705 before the start 701 of the RF pulse 108. The target pulse 107 is then terminated 706 after termination 704 of the RF pulse 108. Plasma is generated at point 707 a short time after the start 701 of the RF pulse 108. The pulse duration 703 of the target pulse 107 is greater than the corresponding pulse duration 700 of the RF pulse 108. In particular, pulse duration 703 is approximately ten times the pulse duration 700 of the RF pulse 108.

This configuration allows optimization of the peak power density at the antenna 100, by reducing the pulse duration 700 with regard to the pulse duration 703 of the target power 107. In particular, the plasma species generated in the afterglow region 708 (extending after the termination 704 of the RF power pulse 108) are utilised for the generation of sputtered ion species.

According to further specific implementations, synchronization of the pulsing (impulsing) of the power supply 107 at the target 102 and the RF pulse (impulse) 108 at the antenna 100 may be in respect of pulse start times 705, 701, pulse end times 706, 704 and/or pulse durations 703, 700 of the respective target power supply 107 and antenna power supply 108.

The invention is defined by the following claims.

**Claims**

1. RF-plasma glow discharge apparatus comprising:

   a containment chamber (101) in which to generate a plasma of ion species;
   a sputter target (102) from which the ion species are generated; means (105) arranged to pulse the power to said sputter target (102)
   an RF antenna (100) arranged to generate the plasma of ion species;
   means (105) arranged to pulse the power at the RF antenna (100);
   **characterised in that**: the apparatus is arranged such that, in operation, the peak power density at the RF antenna (100) is greater than 50 Wcm$^{-2}$.

2. The apparatus as claimed in claim 1 wherein the peak power density at the RF antenna (100) is in the range 50 Wcm$^{-2}$ to 5000 Wcm$^{-2}$.

3. The apparatus as claimed in any preceding claim comprising means (105, 106) to provide pulsed DC power at the sputter target (102) wherein the sputter target (102) is metallic.

4. The apparatus as claimed in claims 1 or 2 comprising means (105, 104) to provide RF power at the sputter target (102) wherein the sputter target (102) is a ceramic.

**5.** The apparatus as claimed in preceding claim wherein the discharge current density at the region of the target (102) is in the range 0.03 Acm$^{-2}$ to 3 Acm$^{-2}$.

**6.** The apparatus as claimed in any preceding claim wherein the RF frequency at the RF antenna (100) is in the range 200 kHz to 100 MHz.

**7.** The apparatus as claimed in any preceding claim further comprising means (105) to synchronise the pulsed power at the sputter target (102) and the RF antenna (100).

**8.** The apparatus as claimed in claim 7 wherein the means to synchronise comprises a communication and a control means coupled to the sputter target (102) and the RF antenna (100) such that the sputter target (102) and RF antenna (100) operate to generate power according to a master and slave synchronised configuration.

**9.** The apparatus as claimed in claim 7 further comprising control means coupled to the sputter target (102) and the RF antenna (100), the control means configured to synchronise the power at the sputter target and the RF antenna.

**10.** An RF-plasma glow discharge process comprising:

pulsing power at a sputter target (102) from which a plasma of ion species is generated within a containment chamber (101);
pulsing power at an RF antenna (100) to generate the plasma of ion species; and
**characterised by**:

generating a peak power density at the RF antenna (100) of greater than 50 Wcm$^{-2}$.

**11.** The process as claimed in claim 10 comprising means (106) to provide RF power at the sputter target.

**12.** The process as claimed in claim 10 or 11 further providing a magnetic field at the region of the target (102) using an array of magnets.

**13.** The process as claimed in any one of claims 10 to 12 further comprising synchronising the pulsed power at the sputter target (102) and the RF antenna (100).

**14.** The process as claimed in claim 13 comprising synchronising the duration of power pulse at the sputter target (102) and the RF antenna (100).

**15.** The process as claimed in claim 13 or 14 comprising synchronising the start and/or termination time of the power pulse at the sputter target (102) and the RF antenna (100).

**Patentansprüche**

**1.** HF-Plasmaglimmentladungsvorrichtung, umfassend:

eine Einschlusskammer (101), in welcher ein Plasma von Ionenspezies zu generieren ist;
ein Sputter-Target (102), aus welchem die Ionenspezies generiert werden;
Mittel (105), welche dazu eingerichtet sind, die Leistung auf das Sputter-Target (102) zu pulsen;
eine HF-Antenne (100), welche dazu eingerichtet ist, das Plasma der Ionenspezies zu generieren;
Mittel (105), welche dazu eingerichtet sind, die Leistung auf die HF-Antenne (100) zu pulsen;
**dadurch gekennzeichnet, dass**:

die Vorrichtung so eingerichtet ist, dass im Betrieb die Spitzenleistungsdichte an der HF-Antenne (100) größer ist als 50 Wcm$^{-2}$.

**2.** Vorrichtung gemäß Anspruch 1, wobei die Spitzenleistungsdichte an der HF-Antenne (100) in dem Bereich von 50 Wcm$^{-2}$ bis 5000 Wcm$^{-2}$ liegt.

**3.** Vorrichtung gemäß einem der vorhergehenden Ansprüche, umfassend Mittel (105, 106) zum Bereitstellen gepulster DC-Leistung auf das Sputter-Target (102), wobei das Sputter-Target (102) metallisch ist.

**4.** Vorrichtung gemäß Anspruch 1 oder 2, umfassend Mittel (105, 104) zum Bereitstellen von HF-Leistung auf das Sputter-Target (102), wobei das Sputter-Target (102) eine Keramik ist.

**5.** Vorrichtung gemäß dem vorhergehenden Anspruch, wobei die Entladungsstromdichte in der Region des Targets (102) in dem Bereich von 0.03 Acm$^{-2}$ bis 3 Acm$^{-2}$ liegt.

**6.** Vorrichtung gemäß einem der vorhergehenden Ansprüche, wobei die HF-Frequenz an der HF-Antenne (100) in dem Bereich von 200 kHz bis 100 MHz liegt.

**7.** Vorrichtung gemäß einem der vorhergehenden Ansprüche, ferner umfassend Mittel (105) zum Synchronisieren der gepulsten Leistung auf das Sputter-Target (102) und die HF-Antenne (100).

**8.** Vorrichtung gemäß Anspruch 7, wobei das Mittel zum Synchronisieren eine Kommunikation und ein Steuermittel umfasst, welche derart an das Sputter-Target (102) und die HF-Antenne (100) gekoppelt ist, dass das Sputter-Target (102) und die HF-Antenne (100) Leistung gemäß einer master-undslave-synchronisierten Konfiguration generieren.

**9.** Vorrichtung gemäß Anspruch 7, ferner umfassend an das Sputter-Target (102) und die HF-Antenne (100) gekoppelte Steuermittel, wobei die Steuermittel dazu eingerichtet sind, die Leistung auf das Sputter-Target und die HF-Antenne zu synchronisieren.

**10.** HF-Plasmaglimmentladungsprozess, umfassend:

Pulsen einer Leistung auf ein Sputter-Target (102), von welchem ein Plasma von Ionenspezies innerhalb einer Einschlusskammer (101) generiert wird;
Pulsen der Leistung auf eine HF-Antenne (100) zum Generieren des Plasmas von Ionenspezies; und
**gekennzeichnet durch**:

Generieren einer Spitzenleistungsdichte auf die HF-Antenne (100) von größer als 50 Wcm$^{-2}$.

**11.** Prozess gemäß Anspruch 10, umfassend Mittel (106) zum Bereitstellen von HF-Leistung auf das Sputter-Target.

**12.** Prozess gemäß Anspruch 10 oder 11, ferner umfassend ein Magnetfeld in der Region des Targets (102) mittels einer Schar von Magneten.

**13.** Prozess gemäß einem der Ansprüche 10 bis 12, ferner umfassend ein Synchronisieren der gepulsten Leistung auf das Sputter-Target (102) und die HF-Antenne (100).

**14.** Prozess gemäß Anspruch 13, umfassend ein Synchronisieren der Dauer von Leistungspulsen auf das Sputter-Target (102) und die HF-Antenne (100).

**15.** Prozess gemäß Anspruch 13 oder 14, umfassend ein Synchronisieren der Start- und/oder Endzeit der Leistungspulse auf das Sputter-Target (102) und die HF-Antenne (100).

**Revendications**

**1.** Appareil à décharge luminescente RF-plasma comprenant :

une chambre de confinement (101) dans laquelle un plasma d'espèces ioniques est généré ;
une cible de pulvérisation (102) à partir de laquelle les espèces ioniques sont générées ;
un moyen (105) conçu pour pulser la puissance à ladite cible de pulvérisation (102) ;
une antenne RF (100) conçue pour générer le plasma d'espèces ioniques ;
un moyen (105) conçu pour pulser la puissance au niveau de l'antenne RF (100) ;
**caractérisé en ce que** :

l'appareil est conçu de sorte que, en fonctionnement, la densité de puissance de crête au niveau de l'antenne RF (100) est supérieure à 50 Wcm$^{-2}$.

**2.** Appareil selon la revendication 1, dans lequel la densité de puissance de crête au niveau de l'antenne RF (100) se situe dans la plage de 50 WCm$^{-2}$ à 5 000 Wcm$^{-2}$.

**3.** Appareil selon l'une quelconque des revendications précédentes, comprenant des moyens (105, 106) pour fournir une puissance continue impulsionnelle au niveau de la cible de pulvérisation (102), dans lequel la cible de pulvérisation (102) est métallique.

**4.** Appareil selon les revendications 1 ou 2, comprenant des moyens (105, 104) pour fournir une puissance RF au niveau de la cible de pulvérisation (102), dans lequel la cible de pulvérisation (102) est une céramique.

**5.** Appareil selon l'une quelconque des revendications précédentes, dans lequel la densité de courant de décharge au niveau de la région de la cible (102) se situe dans la plage de 0,03 Acm$^{-2}$ à 3 Acm$^{-2}$.

**6.** Appareil selon l'une quelconque des revendications précédentes, dans lequel la fréquence RF au niveau de l'antenne RF (100) se situe dans la plage de 200 kHz à 100 MHz.

**7.** Appareil selon l'une quelconque des revendications précédentes, comprenant en outre un moyen (105) de synchronisation de la puissance impulsionnelle au niveau de la cible de pulvérisation (102) et de l'antenne RF (100).

**8.** Appareil selon la revendication 7, dans lequel le moyen de synchronisation comprend une communication et un moyen de commande couplé à la cible de pulvérisation (102) et à l'antenne RF (100) de sorte que la cible de pulvérisation (102) et l'antenne RF (100) fonctionnent pour générer une puissance selon une configuration synchronisée maître-esclave.

**9.** Appareil selon la revendication 7, comprenant en outre un moyen de commande couplé à la cible de pulvérisation (102) et à l'antenne RF (100), le moyen de commande étant configuré pour synchroniser la puissance au niveau de la cible de pulvérisation et de l'antenne RF.

10. Procédé de décharge luminescente RF-plasma comprenant :

> l'impulsion de puissance au niveau d'une cible de pulvérisation (102) à partir de laquelle un plasma d'espèces ioniques est généré au sein d'une chambre de confinement (101) ;
> l'impulsion de puissance au niveau d'une antenne RF (100) pour générer le plasma d'espèces ioniques ; et
> **caractérisé par** :

>> la génération d'une densité de puissance de crête au niveau de l'antenne RF (100) supérieure à 50 WCm$^{-2}$.

11. Procédé selon la revendication 10, comprenant un moyen (106) de fourniture de puissance RF au niveau de la cible de pulvérisation.

12. Procédé selon la revendication 10 ou 11, fournissant en outre un champ magnétique au niveau de la région de la cible (102) en utilisant un réseau d'aimants.

13. Procédé selon l'une quelconque des revendications 10 à 12, comprenant en outre la synchronisation de la puissance impulsionnelle au niveau de la cible de pulvérisation (102) et de l'antenne RF (100).

14. Procédé selon la revendication 13, comprenant la synchronisation de la durée d'impulsion de puissance au niveau de la cible de pulvérisation (102) et de l'antenne RF (100).

15. Procédé selon la revendication 13 ou 14, comprenant la synchronisation du temps de début et/ou de fin de l'impulsion de puissance au niveau de la cible de pulvérisation (102) et de l'antenne RF (100).

**Fig. 1**

Fig. 2

Fig. 3

Fig. 4

**Fig. 5**

**Fig. 6**

**Fig. 7**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 02091461 A
- US 6193855 B

**Non-patent literature cited in the description**

- **V. KOUZNETSOV ; K. MACÁK ; J. M SCHNEIDER ; U. HELMERSSON ; I. PETROV.** *Surf. Coat. Technol.,* 1999, vol. 122, 290-293
- **A.P.EHIASARIAN ; W.-D.MÜNZ ; L.HULTMAN ; U.HELMERSSON ; I.PETROV.** *Surf. Coat. Technol.,* 2003, vol. 267, 163-164
- **D.J.CHRISTIE.** *J. Vac.Sci.Technol.,* 2005, vol. A 23, 330
- **K.YUKIMURA ; R.MIEDA ; H.TAMAGAKI ; T.OKI-MOTO.** *Phys. Stat. Sol.,* 2008, vol. 205 (4), 949-952
- **O.A.MALKIN,.** *Pulsed current and relaxation in gas,* 1974, 27-39
- *J. Vac. Sci. Technol.,* January 2000, vol. A 18 (1